# EUROPEAN PATENT APPLICATION

(11) **EP 1 860 078 A2**
(43) Date of publication of application: **28.11.2007**
(21) Application number: 07380147.4
(22) Date of filing: 24.05.2007
(51) Int. Cl.: C04B 14/30, C04B 28/02

(54) **Heavy mass for manufacturing products with a high radioprotection capacity**

(30) Priority: 26.05.2006 ES 200601392
(71) Applicant: Europea de Minerales y Derivados, S.L., 28016 Madrid (ES)
(72) Inventor: Caruncho Rodado, Juan Manuel, 28016 Madrid (ES)
(74) Representative: Gonzalez Gomez, Maria Virtudes

(57) **Abstract**

The mass, as that of any conventional concrete, is based on cement, aggregates, water and chemical additives that modify the properties of the concrete. According to the invention, the mass uses magnetite as an aggregate, with a highly continuous grain size in order to obtain an optimum homogeneity of the mass as well as a high density which provide an optimum barrier effect against radiation, allowing to reduce substantially the thickness of the wall required without affecting the barrier effect. The mass is ideally suited for obtaining poured concrete, concrete for bricks, concrete for slabs and dry mortar used to build radioactive premises such as radiotherapy and brachytherapy bunkers, radiology walls, etc.

## Description

### OBJECT OF THE INVENTION

The present invention relates to a heavy mass, especially conceived for manufacturing products with a high radioprotection capacity, such as concretes, bricks, slabs and dry mortars.

The object of the invention is to obtain a heavy mass having a high density and homogeneity, with an optimum barrier effect against radiation, allowing a substantial reduction of the wall thickness needed to obtain the same barrier effect for said radiation.

The invention is applicable to any radiological protection system, such as containers and/or mobile barriers in radioactive premises, bunkers for radiotherapy, brachytherapy, walls for TAC and PET radiology, etc.

Thus, the heavy mass of the invention lies within the field of manufacture of raw materials and construction products used to obtain radiologically closed premises.

### BACKGROUND OF THE INVENTION

Concretes with radioprotection capability, in addition to the usual components of cement, water and chemical additives that depend on its intended characteristics, such as strength, setting time, anti-freeze protection, guaranteeing absence of relief, maritime environments, etc., include an aggregate which differentiates them from conventional concrete: This aggregate must be heavy, that is with a high specific density; typically, barite is used, providing densities of up to 3.5 Kg/dm³, depending on the quality of the barite used. The problem with these concretes is that as barite is very crystalline there is a risk that it will be fragmented in the production process, reducing the strength of the concrete, as barite has a high Los Angeles coefficient.

When higher densities are required hematite is used. Even higher densities are obtained by mixing hematite with granulated metal, reaching densities of up to 4.5 Kg/dm³.

In the case of the aforementioned containers and/or mobile barriers of radioactive premises, it is also common to use lead, boronated polyethylene and/or paraffin, leading to problems with the cost and low fusion points in heavy isolation.

### DESCRIPTION OF THE INVENTION

The heavy mass proposed by the invention solves the aforementioned problems in a fully satisfactory manner by obtaining a perfect homogeneity.

Specifically, said heavy mass, in addition to the conventional components of cement, water and chemical additives, includes magnetite as aggregate. Additionally, it is foreseen that this magnetite have a very continuous grain size, which can vary depending on whether the heavy mass is intended for obtaining poured concrete, bricks, slabs or dry mortar.

More specifically, said grain size will be from 0 to 30 millimetres for both poured concrete and bricks, from 0 to 8 millimetres for slabs and from 0 to 2 millimetres for dry mortar.

In this way, an aggregate is obtained with a very low Los Angeles coefficient, so that it is not fragmentable, the morphology of the aggregate being maintained throughout the production process, allowing to guarantee the strength of the final product, which can have a density of 3.2 to 4.1 Kg/dm³, maintaining homogeneity of the mass without adding granulated metal.

### PREFERRED EMBODIMENT OF THE INVENTION

As stated above, the heavy mass proposed by the invention allows obtaining poured concrete, concrete for forming bricks, slabs or dry mortar.

In a specific embodiment for poured concrete, the following mixture has been made:
- 2Kg cement type 42.5 or 52.5;
- 1.150 Kg water;
- 12 Kg Magnetite with 8 mm grain size;
- 12 Kg Magnetite with 30 mm grain size;
- 2% of additives.

This formulation provides densities on the order of 4.06 Kg/dm³.

Increasing the amount of magnetite with a 30 mm grain size by up to 35% more a density of 4.1 was obtained, which is not advisable due to the workability of concrete.

The same mixture, without the magnetite with grain size 8 mm and adding sand to supply fine particles to the concrete, as well as 2000 Kg of magnetite per m³, results in densities over 3.3 Kg/dm³, with better physical characteristics than concretes made with barite.

The remaining doses allow variations of about 15 %.

Tests performed to obtain concrete for bricks give the same results as in the previous case.

To obtain concrete for making slabs, the following mixture was made:
- 2Kg cement type 32.5;
- 1.150 Kg water;
- 25 Kg Magnetite grain size 8 mm;
- 50 grams metal shavings meant to increase strength so that the slab does not break.

This formulation provides densities from 3.9 to 4.1 Kg/dm³, admitting variations in the remaining doses around 10%.

To obtain dry mortar, the following mixture was made:
- 1 Volume cement type 32,5;
- 0.8-0.9 % by weight of cement of water;
- 4 volumes of Magnetite with grain size 0 to 2 mm;
- 2% chemical additive for adherence.

This formulation provides densities from 3.8 to 3.9 Kg/dm³, admitting variations in other doses of around 10%.

## Claims

1. Heavy mass for manufacturing products with a high radioprotection capacity, such as enclosures for radioactive premises and the like, in the form of poured concrete, concrete bricks, concrete slabs or dry mortar, of the type incorporating cement, aggregates, water and chemical additives depending on the intended characteristics of the mass, such as strength, setting time, anti-freeze protection and others, **characterised in that** magnetite is used in it as an aggregate to increase the general density of the mass, with a highly continuous grain size of said magnetite in order to obtain an optimum homogeneity of the mass.

2. Heavy mass for manufacturing products with a high radioprotection capacity, according to claim 1, **characterised in that**, to obtain both poured concrete and concrete for making bricks, magnetite with a grain size under 8 millimetres combined with magnetite with a grain size from 0 to 30 millimetres are used.

3. Heavy mass for manufacturing products with a high radioprotection capacity, according to claim 1, **characterised in that** for , application to obtain concrete for making slabs, the mass includes magnetite with a grain size under 8 millimetres as well as metal shavings.

4. Heavy mass for manufacturing products with a high radioprotection capacity, according to claim 1, **characterised in that** to obtain dry mortar the mass incorporates magnetite with a grain size under 2 millimetres.
